# EUROPÄISCHE PATENTSCHRIFT

(11) **EP 0 936 741 B1**
(45) Veröffentlichungstag und Bekanntmachung des Hinweises auf die Patenterteilung: **29.04.2009**
(21) Anmeldenummer: 99810022.6
(22) Anmeldetag: 14.01.1999
(51) Int. Cl.: H03K 17/95

(54) **Induktiver Näherungsschalter mit einem vorzugsweise aus einem Stück bestehenden Gehäuse**
Inductive proximity switch with a preferably one-piece housing
Commutateur de proximité inductif avec un boîtier préférablement monobloc

(30) Priorität: 13.02.1998 EP 98810116
(43) Veröffentlichungstag der Anmeldung: 18.08.1999
(73) Patentinhaber: Optosys SA, 1762 Givisiez (CH)
(72) Erfinder: Heimlicher, Peter, 1700 Freiburg (CH)
(74) Vertreter: AMMANN PATENTANWÄLTE AG BERN

(56) Entgegenhaltungen:
- EP-A- 0 492 029
- DE-A- 3 934 593
- DE-A- 4 102 542
- DE-C- 19 516 934
- US-A- 3 292 052
- US-A- 4 906 926

## Beschreibung

Die Erfindung betrifft einen induktiven Näherungsschalter gemäss dem Oberbegriff vom Patentanspruch 1.

Ein Näherungsschalter der oben erwähnten Art ist aus der EP-A-0492029 bekannt. Bei diesem Näherungsschalter wird die Spule mit periodischen Sendestromimpulsen der Periode T beaufschlagt. Dazu erzeugen die Mittel zum Speisen der Spule einen Strom, der während einer Dauer T1 von Null verschieden ist, wobei T1 kleiner als T ist, und während der Restdauer der Periode, T-T1, praktisch auf Null gehalten ist. Als Nutzsignal wird mit einer geeigneten elektronischen Schaltung die Empfangsspannung erfasst, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert wird.

In einer Weiterentwicklung des aus der EP-A-0492029 bekannten Näherungsschalters wird die soeben erwähnt, in der Spule induziert Spannung jeweils über ein relativ kurzes Zeitfenster integriert, um nach geeigneter Verarbeitung ein geglättetes Nutzsignal zu erhalten. Dieses Signal wird mit einer Referenzspannung verglichen, um ein Ausgangssignal zu erzeugen, welches das Vorhandensein eines zu erfassenden Körpers in der Nähe des Näherungsschalters signalisiert, falls sich ein solcher Körper dort befindet. Mit einem derartigen Näherungsschalter wird ein überdurchschnittlich guter Schaltabstand bei der Erfassung von metallischen Körpern, z. B. aus Aluminium oder Stahl, erzielt.

In der Patentanmeldung DE-A1-39 34 593 ist ein Sensor zur berührungslosen Erfassung metallischer Werkstoffe beschrieben, dessen Arbeitsweise sich von jener unterscheidet, welche aus der EP-A-0492029 B1 bekannt ist. Die Spulenanordnung des Sensors besteht mindestens aus einer Generatorspule und einer Detektorspule, welche über einen Ferritkern miteinander gekoppelt sind, und ist in ein Edelstahlgehäuse eingebracht. Die Generatorspule wird mit einer dreieckförmig verlaufenden Generatorspannung angesteuert und wird, um brauchbare Schaltabstände zu erzielen, bei tiefen Frequenzen um 100 Hz betrieben.

In der Patentschrift US 3 292 052 ist ein Näherungsschalter beschrieben, welcher nach demselben Messprinzip arbeitet, wie der Sensor gemäss DE-A1-39 34 593. Der Näherungsschalter umfasst eine Erregerspule, zwei Empfangsspulen und eine Abdeckung aus rostfreiem Stahl, welche mit Montagehaltern versehen ist. Nachteilig ist, dass eine relativ dünne Abdeckung gewählt werden muss, um akzeptable Schaltabstände zu erzielen, und sie daher nur einen minimalen Schutz vor mechanischen Beschädigungen bietet.

Die Komponenten bekannter Näherungsschalter, die nach dem in der EP-A-0492029 B1 beschriebenen Prinzip arbeiten, sind üblicherweise in einem aus zwei oder mehr Teilen bestehenden Gehäuse enthalten, das sich in der Regel zumindest aus einem länglichen, metallischen Zylinder und einer Kappe aus Kunststoff, welche die aktive Fläche 24, d. h. die Austrittsfläche des von der Spule erzeugten magnetischen Feldes, abschliesst, zusammensetzt. Ein solches Gehäuse ist für Anwendungen ungeeignet, bei denen der Näeherungsschalter Schlägen auf die Kunststoffkappe, besonders aggressiven Umgebungen oder erhöhtem Umgebungsdruck ausgesetzt ist. Solche Umgebungsbedingungen machen ein sehr robustes Gehäuse erforderlich. Es ist insbesondere sehr schwierig zu erreichen, dass die Kappe des Näeherungsschalters einen flüssigkeits- und gasdichten Verschluss des Zylinders bildet. Bei Verwendung eines üblichen Näherungsschalters in den genannten Umgebungen ist mit einer raschen Beschädigung der Komponenten des Näeherungsschalters und daher mit einer relativ kurzen Lebensdauer desselben zu rechnen.

Der Erfindung liegt daher die Aufgabe zugrunde, einen induktiven Näherungsschalter der in der EP-A-0492029 B1 beschriebenen Art bereitzustellen, der für den Einsatz bei mechanischer Beanspruchung der aktiven Fläche, in aggressiven Umgebungen und bei erhöhtem Umgebungsdruck geeignet ist, mit dem aber nach wie vor ein überdurchschnittlich guter Schaltabstand bei der Erfassung von metallischen Körpern, z. B. aus Aluminium oder Stahl, erzielbar ist.

Diese Aufgabe wird erfindungsgemäss mit einem induktiven Näherungsschalter der in der EP-A-0492029 B1 beschriebenen Art gelöst, der durch die im kennzeichnenden Teil des Patentanspruchs 1 definierten Merkmale gekennzeichnet ist.

Dank seiner Robustheit ist ein solcher Näherungsschalter sogar bei sehr anspruchsvollen Einsatzfällen bei sehr schwierigen-Umgebungsbedingungen verwendbar, wobei die guten Eigenschaften des Näeherungsschalters, insbesondere der damit erzielbare, überdurchschnittlich gute Schaltabstand bei der Erfassung von metallischen Körpern, z. B. aus Aluminium oder Stahl, beibehalten werden.

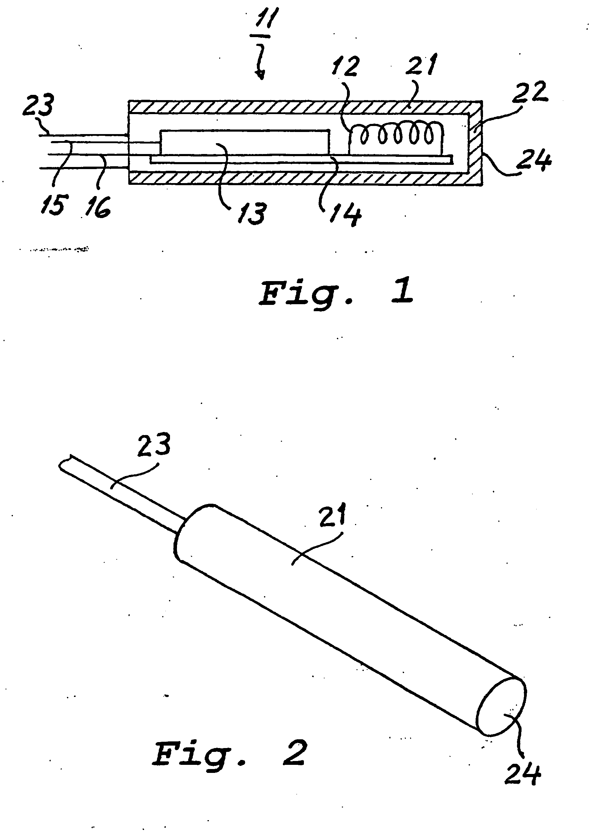

Ein Ausführungsbeispiel der Erfindung wird im folgenden anhand der beiliegenden Figuren 1 und 2 erläutert.
- Figur 1: zeigt einen schematischen Querschnitt eines erfindungsgemässen Näherungsschalters,
- Figur 2: zeigt eine perspektivische Ansicht des Näherungsschalters gemäss Fig. 1.

Wie in Fig. 1 schematisch dargestellt, enthält ein erfindungsgemässer Näherungsschalter 11 eine Spule 12 und eine elektronische Schaltung 13. Diese Schaltung 13 enthält Mittel zum Speisen der Spule mit periodischen Sendestromimpulsen der Periode T, die typischerweise zwischen 50 und 500 Mikrosekunden gewählt wird und Mittel zum Verarbeiten von Signalen, die induzierten Spannungen entsprechen, welche in der Spule entstehen, wenn ein zu erfassender Körper sich im Einflussbereich des variablen magnetischen Feldes befindet, das von der Spule aufgebaut wird, wenn diese mit dem periodischen Sendestrom gespiesen wird. Die Schaltung 13 arbeitet nach der in der in der EP-A-0492029 B1 beschriebenen Funktionsweise.

Die Spule 12 und die Schaltung 13 sind beispielsweise auf eine gedruckte Leiterplatte 14 montiert. Die elektronische Schaltung 13 ist über Leitungen 15 und 16 eines Kabels 23 mit dem Gerät oder System (nicht gezeigt) verbunden, in dem die mit dem Näherungsschalter 11 gewonnenen Signale weiterverarbeitet werden.

Wie aus Fig. 1 ersichtlich, sind alle Komponenten eines erfindungsgemässen Näherungsschalters in einem aus einem Stück bestehenden Gehäuse 21 angeordnet, welches, wie aus Fig. 2 ersichtlich, vorzugsweise zylindrisch ist. Das Gehäuse 21 kann aber eine andere geeignete Form haben. Es kann z.B. die Form eines länglichen Quaders haben. Das Gehäuse 21 umfasst auch den Abschluss 22 des Zylinders auf der Seite der aktiven Fläche 24 des Näeherungsschalters. Dieser Abschluss 22 ersetzt die in bisher bekannten Ausführungen verwendete Kappe und hat annähernd die gleiche Wandstärke wie eine solche Kappe. Wie aus Fig. 1 ersichtlich, hat der Abschluss 22 eine Wandstärke, die ausreichend ist, um einen guten mechanischen Schutz der sich dahinter befindlichen Spule zu ermöglichen. Bei einem zylindrischen Gehäuse 21 liegt die Wandstärke des Abschlusses 22 vorzugsweise in einem Bereich von 3 bis 10% des Aussendurchmessers des Gehäuses 21. Bei einem nicht zylindrischen Gehäuse liegt die Wandstärke des Abschlusses 22 vorzugsweise in einem Bereich von 3 bis 10% des Durchmessers eines Kreises, welcher der aktiven Fläche des Näeherungsschalters eingeschrieben ist.

Das Gehäuse besteht aus einem Metall, welches nicht ferromagnetisch ist und welches einen relativ hohen spezifischen elektrischen Widerstand aufweist, vorzugsweise aus nichtmagnetischem rostfreiem Stahl. Wegen dieser

Eigenschaften entstehen in der aktiven Fläche 24 während des Betriebs des Näherungsschalters nur sehr kleine Wirbelströme, und die davon in der Spule 12 induzierten Spannungen sind im Messfenster des Nutzsignals vernachlässigbar klein. In zu erfassenden metallischen Körpern aus beispielsweise Stahl oder Aluminium entstehen hingegen wesentlich stärkere Wirbelströme, welche in der Spule Spannungen induzieren, die so stark sind, dass sie die Erfassung solcher Körper mit einem überdurchschnittlich grossen Schaltabstand ermöglichen.

Das Gehäuse 21 besteht vollständig aus Metall und bietet daher den Komponenten des Näherungsschalters 11 einen sehr guten Schutz gegen aggressive Umgebungen.

## Patentansprüche

1. Induktiver Näherungsschalter mit
- einer Spule,
- Mitteln zum Speisen der Spule mit periodischen Sendestromimpulsen,
- Mitteln zum Verarbeiten von Signalen, die induzierten Spannungen entsprechen, die nach dem Ende eines Sendestromimpulses durch den in dem zu erfassenden Körper fliessenden abklingenden Strom, der dort vorher infolge der durch die vom Sendestromimpuls induzierten Spannung fliesst, in der Spule induziert werden,
welcher Näherungsschalter
**dadurch gekennzeichnet ist, dass**
die Spule (12), die Mittel zum Speisen der Spule mit periodischen Sendestromimpulsen und die Mittel zum Verarbeiten von Signalen in einem auf der Seite der aktiven Fläche (24) des Näherungsschalters abgeschlossenen Gehäuse (21) angeordnet sind, welches aus einem Metall besteht, das nicht ferromagnetisch ist und einen relativ hohen spezifischen elektrischen Widerstand aufweist.

2. Induktiver Näherungsschalter gemäss Anspruch 1, **dadurch gekennzeichnet, dass** das Gehäuse (21) aus einem Stück besteht.

3. Induktiver Näherungsschalter nach einem der Ansprüche 1 oder 2, **dadurch gekennzeichnet, dass** das Gehäuse (21) aus nichtmagnetischem rostfreiem Stahl besteht.

4. Induktiver Näherungsschalter nach einem der vorangehenden Ansprüche, **dadurch gekennzeichnet, dass** die Periode der Sendestromimpulse zwischen 50 und 500 Mikrosekunden liegt.

5. Induktiver Näherungsschalter nach einem der vorangehenden Ansprüche, **dadurch gekennzeichnet, dass** das Gehäuse (21) zylindrisch ist und einen Abschluss (22) hat, dessen Wandstärke in einem Bereich von 3 bis 10 % des Aussendurchmessers des Gehäuses (21) liegt.

6. Induktiver Näherungsschalter nach einem der vorangehenden Ansprüche, **dadurch gekennzeichnet, dass** das Gehäuse (21) einen Abschluss (22) hat, dessen Wandstärke in einem Bereich von 3 bis 10% des Durchmessers eines Kreises liegt, welcher der aktiven Fläche des Näherungsschalters eingeschrieben ist.

## Claims

1. Inductive proximity switch comprising
- a coil,
- means for supplying the coil with periodic transmitting current pulses,
- means for processing signals that correspond to voltages induced in the coil after the end of a transmitting current pulse by the decaying current previously flowing in the body that is to be detected due to the voltage induced therein by the transmitting current pulse,
which proximity switch
is **characterised in that**
the coil (12), the means for supplying the coil with periodic transmitting current pulses, and the means for processing signals are arranged in a housing (21) that is closed on the side of the active surface (24) of the proximity switch and consists of a metal that is not ferromagnetic and has a relatively high specific electric resistance.

2. Inductive proximity switch according to claim 1, **characterised in that** the housing (21) is made of one piece.

3. Inductive proximity switch according to one of claims 1 or 2, **characterised in that** the housing (21) is made of non-magnetic stainless steel.

4. Inductive proximity switch according to one of the preceding claims, **characterised in that** the period of the transmitting current pulses lies between 50 and 500 microseconds.

5. Inductive proximity switch according to one of the preceding claims, **characterised in that** the housing (21) is cylindrical and has a closure (22) whose wall thickness lies in a range of 3 to 10 % of the outer diameter of the housing (21).

6. Inductive proximity switch according to one of the preceding claims, **characterised in that** the housing (21) has a closure (22) whose wall thickness is in a range of 3 to 10 % of the diameter of a circle inscribed into the active surface of the proximity switch.

## Revendications

1. Commutateur de proximité inductif comprenant
- une bobine,
- des moyens pour alimenter à la bobine des impulsions de courant d'émission périodiques,
- des moyens pour le traitement de signaux qui correspondent à des tensions induites après la fin d'une impulsion de courant d'émission dans la bobine par le courant décroissant qui circule dans le corps à détecter en raison de la tension induite dans celui-ci par l'impulsion de courant d'émission,
lequel commutateur de proximité
est **caractérisé en ce que**
la bobine (12), les moyens pour alimenter à la bobine des impulsions de courant d'émission périodiques et les moyens pour le traitement de signaux sont agencés dans un boîtier (21) fermé du côté de la surface active (24) du commutateur de proximité, lequel est constitué d'un métal non ferromagnétique et présente une résistance électrique spécifique relativement élevée.

2. Commutateur de proximité inductif selon la revendication 1, **caractérisé en ce que** le boîtier (21) est constitué d'une seule pièce.

3. Commutateur de proximité inductif selon l'une des revendications 1 ou 2, **caractérisé en ce que** le boîtier (21) est constitué d'acier inoxydable non-magnétique.

4. Commutateur de proximité inductif selon l'une des revendications précédentes, **caractérisé en ce que** la période des impulsions de courant d'émission est située entre 50 et 500 microsecondes.

5. Commutateur de proximité inductif selon l'une des revendications précédentes, **caractérisé en ce que** le boîtier (21) est cylindrique et comporte un élément de fermeture (22) dont l'épaisseur de paroi est situé dans une plage de 3 à 10 % du diamètre extérieur du boîtier (21).

6. Commutateur de proximité inductif selon l'une des revendications précédentes, **caractérisé en ce que** le boîtier (21) comporte un élément de fermeture (22) dont l'épaisseur de paroi est situé dans une plage de 3 à 10 % du diamètre d'un cercle inscrit dans la surface active du commutateur de proximité.
